# EUROPEAN PATENT APPLICATION

(11) **EP 4 679 964 A1**
(43) Date of publication of application: **14.01.2026**
(21) Application number: 23927331.1
(22) Date of filing: 10.03.2023
(51) Int. Cl.: H05K 13/02

(54) **FEEDER**

(71) Applicant: Fuji Corporation, Chiryu-shi, Aichi 472-8686 (JP)
(72) Inventor: TAKADA Yukinori, Chiryu-shi, Aichi 472-8686 (JP)
(74) Representative: Grünecker Patent- und Rechtsanwälte PartG mbB
(86) International application number: PCT/JP2023/009439
(87) International publication number: WO 2024/189707

(57) **Abstract**

A feeder is a feeder for conveying a carrier tape accommodating components, the feeder including: a splicing device configured to connect a rear end portion of the carrier tape being conveyed and a front end portion of the carrier tape for replenishment to each other by using a connection member in order to ensure connection between the carrier tape being conveyed and the carrier tape for replenishment.

## Description

### Technical Field

The present description relates to a feeder.

### Background Art

In the conventional art, a feeder that connects a carrier tape for replenishment to a carrier tape being conveyed is known (for example, see Patent Literature 1). The carrier tape includes a base tape and a cover tape attached to the base tape to close openings of cavities. The carrier tape being conveyed and the carrier tape for replenishment are each wound around a reel. Each reel is rotatably attached to a reel shaft provided in the feeder, to feed the tape by rotation of a corresponding sprocket.

The feeder includes tape connection means that connects the carrier tape being conveyed and the carrier tape for replenishment to each other. The tape connection means has a thermal adhesion plate and a thermal adhesion support plate for integrating the carrier tape being conveyed and the carrier tape for replenishment by thermal adhesion.

In the feeder described above, when a component shortage of the carrier tape being conveyed is detected, the carrier tape for replenishment is advanced by the rotation of the sprocket, and when a front end portion of the carrier tape for replenishment overlaps a rear end portion of the carrier tape being conveyed, the thermal adhesion plate of the tape connection means is lowered. According to such a process, since the rear end portion of the carrier tape being conveyed and the front end portion of the carrier tape for replenishment are sandwiched between the thermal adhesion plate and the thermal adhesion support plate and thermally adhere to each other, the carrier tape being conveyed and the carrier tape for replenishment are connected to each other.

Therefore, with the feeder described above, when the components of the carrier tape being conveyed run out, the carrier tape for replenishment is automatically spliced to the carrier tape being conveyed without work of a worker, and the conveyance of the carrier tape in which the component is accommodated in the cavity can be continued.

### Citation List

### Patent Literature

Patent Literature 1:JPH03-75600U

### Summary of the Invention

### Technical Problem

In the feeder disclosed in Patent Literature 1, the carrier tape being conveyed and the carrier tape for replenishment are connected to each other by overlapping the carrier tapes in a tape thickness direction and causing the carrier tapes to thermally adhere to each other. However, in this structure, a pitch between feed holes before and after a joint portion between the carrier tape being conveyed and the carrier tape for replenishment may deviate from a predetermined pitch, or the strength of the carrier tape during the conveyance may not be ensured.

An object of the present description is to provide a feeder capable of connecting a carrier tape being conveyed and a carrier tape for replenishment to each other with a configuration different from the configuration disclosed in Patent Literature 1.

### Solution to Problem

The present description discloses a feeder for conveying a carrier tape accommodating components, the feeder including: a splicing device configured to connect a rear end portion of the carrier tape being conveyed and a front end portion of the carrier tape for replenishment to each other by using a connection member.

According to the present disclosure, since the connection member is used for the connection between the carrier tape being conveyed and the carrier tape for replenishment, the connection can be ensured.

### Brief Description of Drawings

Fig. 1 is a perspective view of a feeder according to an embodiment.
Fig. 2 is a perspective view of a carrier tape with a connection member.
Fig. 3 is a perspective view of a front portion of the feeder.
Fig. 4 is a perspective view of a rear portion of the feeder.
Fig. 5 is a perspective view of a component detection sensor, a cutting device, and a moving mechanism of a splicing device provided in the feeder.
Fig. 6 is a perspective view showing an in-operation state and an operation completion state of the cutting device.
Fig. 7 is a perspective view of a tape holder and the splicing device provided in the feeder.
Fig. 8 is a perspective view showing a holding release state of the tape holder.
Fig. 9 is a view showing a structure of a positioning section of the tape holder.
Fig. 10 is a view showing a structure for detecting a component of a carrier tape for replenishment in the tape holder.
Fig. 11 is a view showing a state in which a carrier tape being conveyed and the carrier tape for replenishment are connected by the splicing device using the connection member.

### Description of Embodiments

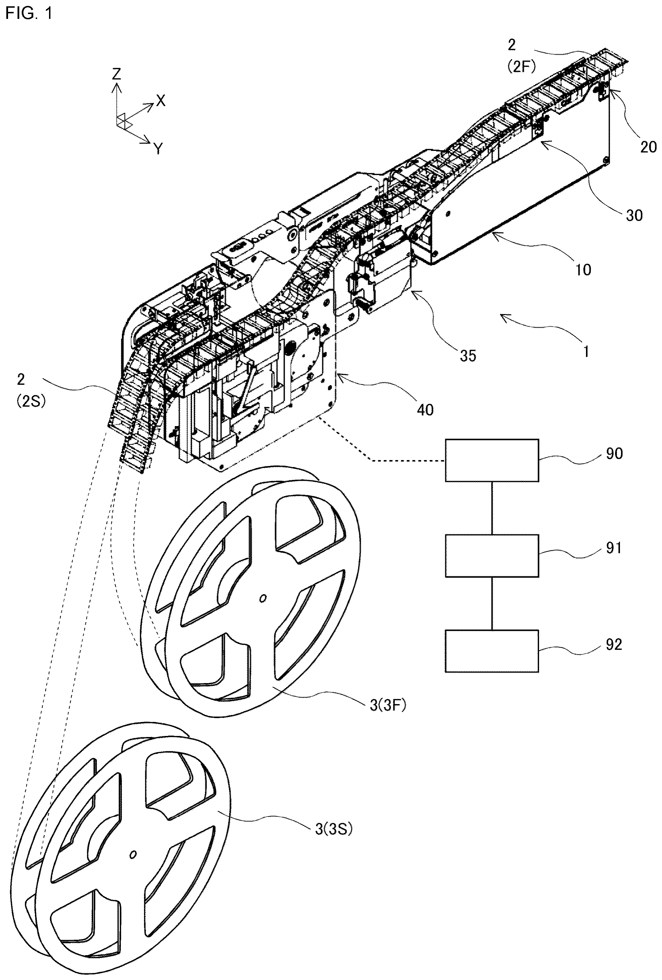

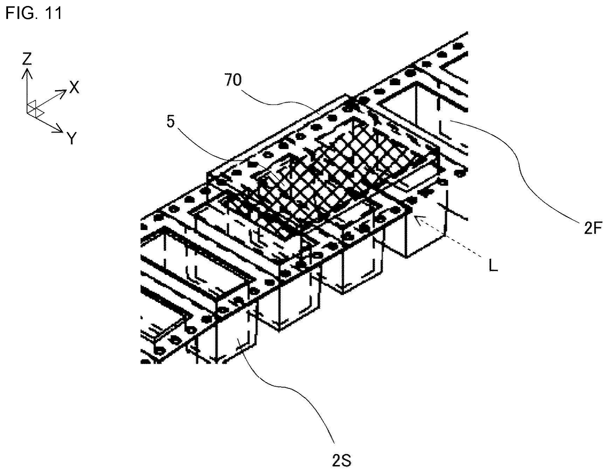

Hereinafter, an embodiment of a feeder according to the present disclosure will be described with reference to Figs. 1 to 11.

### 1. Summary

Feeder 1 is a tape feeder that conveys carrier tape 2 that accommodates components. Feeder 1 is detachably mounted in a slot of a component mounter provided on a board production line for producing an electronic board. This component mounter has multiple slots, and can mount multiple feeders 1. Each feeder 1 supplies the component to a component pickup position by conveying carrier tape 2, and causes a suction nozzle, a gripping chuck, or the like attached to a mounting head of the component mounter to hold the component. The component is supplied to the component pickup position, held by the suction nozzle or the like, and then mounted on the electronic board.

### 2. Configuration of Carrier Tape

Carrier tape 2 is a tape that accommodates multiple components and extends in a longitudinal direction. The component is an electronic component mounted on the electronic board, and includes, for example, a minute component of 0201 size (0.2 mm × 0.1 mm) and a large component. Carrier tape 2 is wound around disk-shaped reel 3. Carrier tape 2 may be formed to have a wide width such as 12 mm.

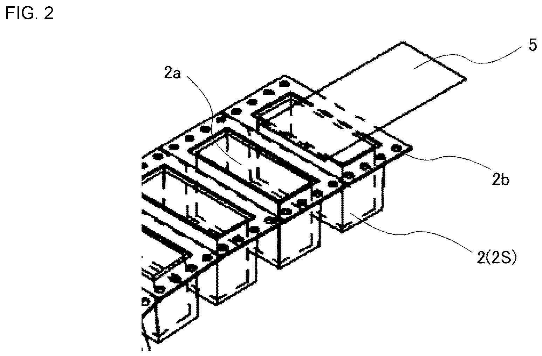

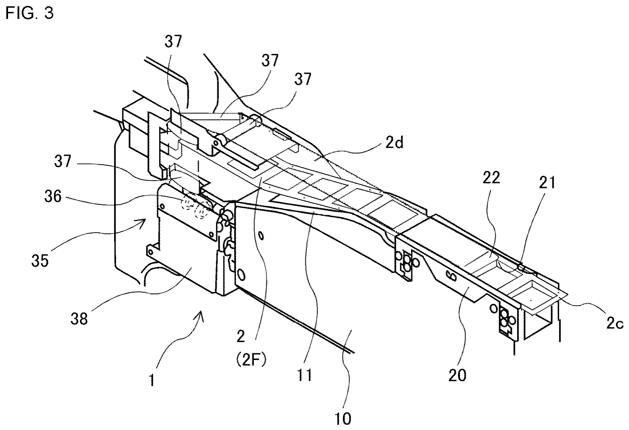

As shown in Fig. 2, carrier tape 2 has cavities 2a. Cavities 2a are accommodation spaces for accommodating the components, and are provided side by side at predetermined intervals (for example, 4 mm or 8 mm) in a tape longitudinal direction. Carrier tape 2 is a tape in which base tape 2c provided with cavities 2a and cover tape 2d that covers openings of cavities 2a are joined (see Fig. 3). Carrier tape 2 is made of a flexible material such as resin, plastic, or paper.

As shown in Fig. 2, base tape 2c of carrier tape 2 has feed holes 2b. Feed hole 2b is a substantially circular or elliptical through hole with which an engagement protrusion of a sprocket of feeder 1 is engaged. Feed hole 2b penetrates in a tape thickness direction. Feed holes 2b are provided at both end portions in a tape width direction. Feed holes 2b are arranged at predetermined pitches (for example, 4 mm or 8 mm) in the tape longitudinal direction. Feed holes 2b are arranged in parallel with cavities 2a in a row in the tape longitudinal direction in base tape 2c.

Carrier tape 2 may be an embossed tape in which a protruding portion that protrudes downward from a planar portion is provided for each cavity 2a in base tape 2c, or may be a paper tape in which the openings of the through holes provided as cavities 2a in base tape 2c are covered with cover tape 2d from both sides in the tape thickness direction or the openings of cavities 2a provided in a concave shape in the planar portion of base tape 2c is covered with cover tape 2d from one side in the tape thickness direction. Fig. 1 or Fig. 2 shows embossed carrier tape 2.

### 3. Configuration of Feeder

Feeder 1 is an automatic splicing feeder having a function of conveying carrier tape 2 to expose the component such that the component can be taken out at the component pickup position, and a function of connecting two carrier tapes 2 to each other. As shown in Fig. 1, feeder 1 includes feeder main body 10, tape guide 20, tape conveyance mechanism 30, cover tape discharge mechanism 35, splicing device 40, and control device 90.

Feeder main body 10 is a main body member including a skeleton portion to which tape guide 20, tape conveyance mechanism 30, cover tape discharge mechanism 35, and splicing device 40 are attached and an attachment portion to be attached to the slot of the component mounter. Feeder main body 10 may include a reel holding section that rotatably holds reel 3 around which carrier tape 2 is wound. Feeder main body 10 is formed in a flat shape that is attachable to and detachable from the slot of the component mounter.

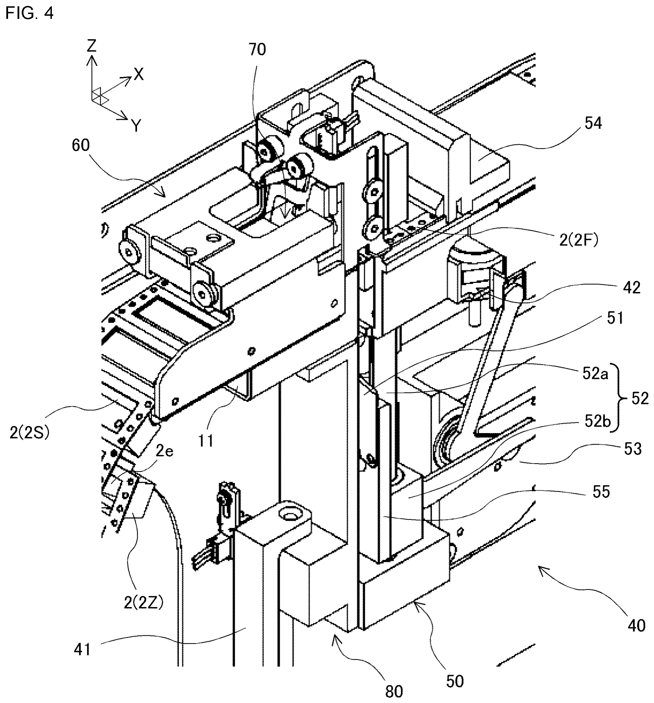

As shown in Figs. 3 and 4, feeder main body 10 has conveyance path 11 that conveys and supports carrier tape 2. Conveyance path 11 supports carrier tape 2 from below. For example, conveyance path 11 supports carrier tape 2 by coming into contact with a lower surface of a flange portion at both end portions of carrier tape 2 in tape width direction Y. Conveyance path 11 extends along tape conveyance direction X and is formed, for example, in a U-shape in cross section. Conveyance path 11 supports carrier tape 2 at an upper end of an upright wall in tape width direction Y having a U-shaped cross section.

Tape guide 20 is a guide member that guides carrier tape 2 to be conveyed. Tape guide 20 is disposed above conveyance path 11. Tape guide 20 is detachably mounted on a front side and an upper side of feeder main body 10 in tape conveyance direction X. Tape guide 20 is formed to have a U-shaped cross section to be able to abut on an upper surface and a side surface of carrier tape 2. Carrier tape 2 is guided in contact with an upper wall and a side wall of tape guide 20 when being conveyed in tape conveyance direction X. Tape guide 20 includes window section 21 that is opened in the upper wall, and fold-back section 22 that folds back cover tape 2d peeled off from base tape 2c of carrier tape 2 to a side opposite to base tape 2c. The component pickup position is located in window section 21.

Carrier tape 2 is inserted into a tape inlet of feeder main body 10, and enters tape guide 20 while being supported by conveyance path 11. When the sprocket rotates in a state where feed holes 2b of carrier tape 2 are engaged with the sprocket on a tape outlet side described later, carrier tape 2 is fed in tape conveyance direction X. In synchronization with the conveyance of carrier tape 2, cover tape 2d of carrier tape 2 is peeled off from base tape 2c and folded back at fold-back section 22. As a result, the components in cavities 2a are exposed able to be taken out. After the exposure, the component is held by the suction nozzle or the like of the component mounter and transferred to the electronic board when the component reaches the component pickup position.

Tape conveyance mechanism 30 is a mechanism that conveys carrier tape 2. Tape conveyance mechanism 30 includes a sprocket that conveys carrier tape 2 by rotation, and a drive motor such as an electric motor that generates power for rotating the sprocket. The sprocket is a rotatable disk body, and has the engagement protrusion inserted into feed hole 2b of carrier tape 2 to be conveyed. The sprocket and the drive motor are disposed below conveyance path 11. When the drive motor is driven in a state where the engagement protrusion of the sprocket is inserted into feed hole 2b of carrier tape 2, carrier tape 2 is conveyed in accordance with the driving of the drive motor.

It is preferable that the sprocket of tape conveyance mechanism 30 is disposed close to a peel-off position of cover tape 2d or the component pickup position in feeder 1 in order to prevent a positional deviation in tape width direction Y in carrier tape 2. The sprocket and the drive motor may be directly connected to each other, or may be indirectly connected to each other via a speed reducer. In addition, it is preferable that the drive motor not only rotates the sprocket only in a direction in which carrier tape 2 is fed forward in tape conveyance direction X but also rotates the sprocket in a direction opposite to the forward feeding direction, for example, in order to adjust a position of carrier tape 2 in tape conveyance direction X or to improve the positioning accuracy.

Cover tape discharge mechanism 35 is a mechanism that discharges cover tape 2d peeled off from base tape 2c of carrier tape 2 to the outside of feeder main body 10. Cover tape discharge mechanism 35 lowers and discharges cover tape 2d, which is peeled off from base tape 2c on an upstream side of the component pickup position of feeder 1 in tape conveyance direction X and folded back to pass above conveyance path 11, along a side surface of feeder main body 10.

Cover tape discharge mechanism 35 includes winding gear 36, winding roller 37, and winding lever 38. Winding gear 36 rotates in a direction in which cover tape 2d is discharged in synchronization with the conveyance of carrier tape 2 in tape conveyance direction X. Winding roller 37 rotates to assist the discharge conveyance of cover tape 2d. Winding lever 38 is an operation section for rotating winding gear 36. Winding roller 37 may be provided at multiple positions such that cover tape 2d is discharged and conveyed along a predetermined path through which cover tape 2d is folded back at fold-back section 22 and reaches winding gear 36.

Carrier tape 2 is inserted into the tape inlet of feeder main body 10 and supported by conveyance path 11, and is set such that feed hole 2b of carrier tape 2 is engaged with the sprocket of tape conveyance mechanism 30 on the tape outlet side. In addition, cover tape 2d of carrier tape 2 is completely peeled off from base tape 2c starting from fold-back section 22 on the upstream side of the component pickup position in tape conveyance direction X, and is set to engage with winding gear 36 along the predetermined path.

When the sprocket rotates, carrier tape 2 is fed in tape conveyance direction X, and cover tape 2d is discharged toward the outside of feeder 1 while being peeled off from base tape 2c in conjunction with the conveyance of carrier tape 2. In this case, components in cavities 2a of base tape 2c are exposed able to be taken out. After the exposure, the component is held by the suction nozzle or the like of the component mounter and transferred to the electronic board when the component reaches the component pickup position.

Splicing device 40 is a device that connects two new and old carrier tapes 2 (specifically, cover tapes 2d thereof) to each other without work performed by a worker. The splicing is performed, for example, in order to switch from carrier tape 2 being conveyed in which the number of remaining components is small to carrier tape 2 for replenishment in which the number of accommodated components is large or in order to switch between different types of carrier tapes 2. Splicing device 40 connects subsequent carrier tape 2 to carrier tape 2 conveyed by feeder 1 using splicing tape 5 that is a connection member.

Hereinafter, carrier tape 2 being conveyed ahead with feeder 1 as a conveyance target is referred to as preceding tape 2F, and carrier tape 2 for replenishment which follows preceding tape 2F is referred to as following tape 2S. Reel 3 on which preceding tape 2F is wound is referred to as preceding reel 3F, and reel 3 on which following tape 2S is wound is referred to as following reel 3S.

Further, splicing device 40 may be a unit provided integrally with feeder 1, or may be a unit detachably provided in feeder 1. Hereinafter, in the present embodiment, it is assumed that splicing device 40 is a unit integrated with feeder 1.

Splicing device 40 is integrated and incorporated in feeder 1. As shown in Fig. 4, splicing device 40 includes unit body 41, component detection sensor 42, cutting device 50, tape holder 60, splicing crimping section 70, and moving mechanism 80.

Unit body 41 is a body member including a skeleton portion to which another member in splicing device 40 is attached. Unit body 41 is provided integrally with feeder main body 10 of feeder 1. In a structure in which splicing device 40 is detachably provided in feeder 1, unit body 41 may include an attachment portion attached to feeder main body 10.

At least a part of conveyance path 11 is provided in unit body 41. Preceding tape 2F pulled out from preceding reel 3F is held to be conveyable to conveyance path 11. Conveyance path 11 provided in unit body 41 can move by sliding in up-down direction Z with respect to unit body 41 and thus feeder main body 10 by moving mechanism 80.

Component detection sensor 42 is a sensor that detects the components accommodated in cavities 2a of preceding tape 2F. Component detection sensor 42 is, for example, a non-contact or optical sensor such as a camera, and outputs a signal corresponding to the presence or absence of the components in cavities 2a. The output signal of component detection sensor 42 is supplied to control device 90. Control device 90 detects the presence or absence of the components of preceding tape 2F based on the output signal of component detection sensor 42. Then, when it is detected that the state of cavity 2a is changed from a component presence state to a component absence state in cavity 2a immediately after cavity 2a in the component presence state, a final component (hereinafter, referred to as a final component) in preceding tape 2F is detected, and a position thereof is specified.

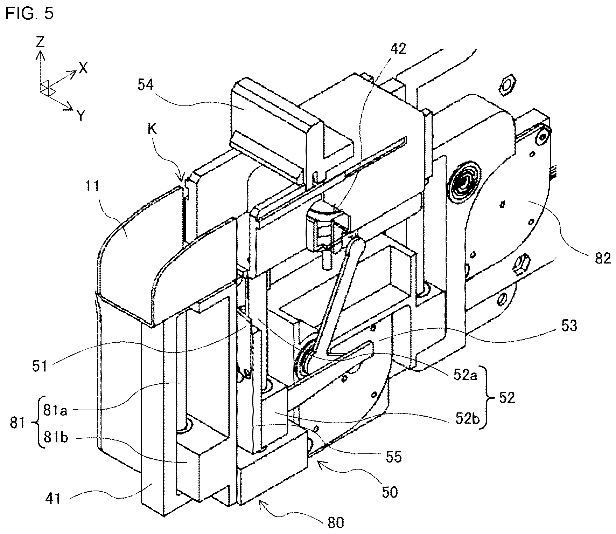

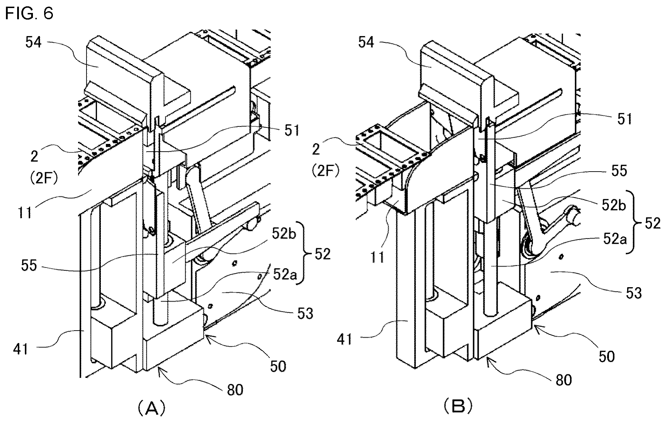

Cutting device 50 is a device that cuts preceding tape 2F. Cutting device 50 cuts a central portion of preceding tape 2F in the tape longitudinal direction between cavities 2a. Cutting device 50 is integrally attached to conveyance path 11 of feeder main body 10. Cutting device 50 may be attached to unit body 41. As shown in Fig. 4, Fig. 5, (A) of Fig. 6, and (B) of Fig. 6, cutting device 50 includes cutter 51, movement guide section 52, cutter drive section 53, and pressing section 54.

Cutter 51 is a blade section that cuts preceding tape 2F. Cutter 51 is movable in up-down direction Z with respect to conveyance path 11. Conveyance path 11 has a portion divided into front and rear portions with gap K at the central portion in tape conveyance direction X. Cutter 51 can move upward through gap K to a position above an upper surface of preceding tape 2F on conveyance path 11. Cutter 51 is movable between a lower end position at which preceding tape 2F is not cut and an upper end position at which preceding tape 2F is cut.

Cutter 51 is held by plate-shaped cutter holding section 55, and is attached to an upper end portion of cutter holding section 55. Cutter 51 may be attachable to and detachable from cutter holding section 55. Cutter 51 moves integrally with the movement of cutter holding section 55 in up-down direction Z. Cutter 51 cuts a predetermined portion on a rear side in tape conveyance direction X with respect to the final component among the components accommodated in preceding tape 2F, as a splicing portion. Specifically, the predetermined portion is, for example, the central portion in tape conveyance direction X between cavity 2a accommodating the final component and empty cavity 2a (indicated by empty cavity 2e in Fig. 4) immediately after cavity 2a accommodating the final component.

Movement guide section 52 is a section that supports and guides cutter holding section 55 and thus cutter 51 such that cutter holding section 55 and cutter 51 are movable in up-down direction Z relative to conveyance path 11. Movement guide section 52 includes body side member 52a attached to unit body 41 and cutter side member 52b attached to cutter holding section 55. Body side member 52a extends in a rod shape in up-down direction Z. Cutter side member 52b includes a groove portion or a hole portion, into which body side member 52a is fitted, corresponding to body side member 52a. Cutter side member 52b moves up and down integrally with cutter holding section 55.

Cutter drive section 53 is a section that generates a driving force to move cutter holding section 55 and thus cutter 51 in up-down direction Z. Cutter drive section 53 is, for example, an electric motor. Cutter drive section 53 is attached to unit body 41. Cutter drive section 53 generates a driving force to move cutter 51 from the lower end position to the upper end position when a cutting instruction to cut preceding tape 2F is issued.

Pressing section 54 is a section that immovably presses preceding tape 2F when cutter 51 cuts preceding tape 2F. Pressing section 54 is in contact with the upper surface of preceding tape 2F and surrounds cutter 51 at the upper end position of cutter 51 without interfering with cutter 51. That is, pressing section 54 is formed in, for example, a frame shape or a block shape in which the central portion in tape conveyance direction X is cut out, such that pressing section 54 comes into contact with upper surfaces of portions that sandwich the cutting portion of preceding tape 2F in tape conveyance direction X without interfering with cutter 51 at the upper end position of cutter 51.

Pressing section 54 is disposed above conveyance path 11. Pressing section 54 is supported by unit body 41 to be movable in tape conveyance direction X. Pressing section 54 moves in tape conveyance direction X in synchronization with the movement of cutter holding section 55 and cutter 51 in up-down direction Z. Pressing section 54 may move in conjunction with the movement of cutter holding section 55 by applying the driving force of cutter drive section 53 via a link mechanism, or may move by the driving force from the drive section provided separately from cutter drive section 53.

Tape holder 60 is a holding section that holds following tape 2S pulled out from following reel 3S. Following tape 2S is held in a state of being positioned by tape holder 60. Following tape 2S is not conveyed in tape conveyance direction X in a state of being positioned by tape holder 60, but can be conveyed in tape conveyance direction X integrally with preceding tape 2F by tape conveyance mechanism 30 after being connected to preceding tape 2F.

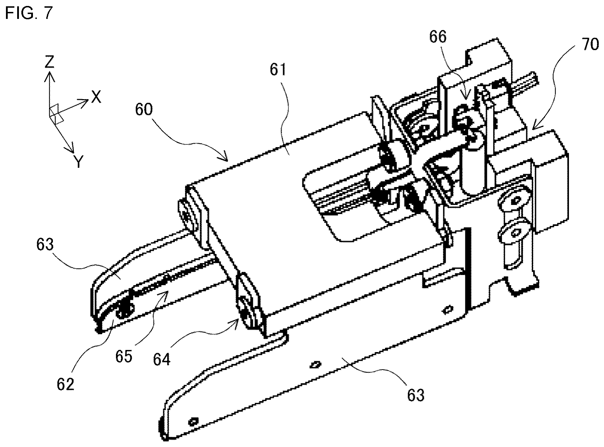

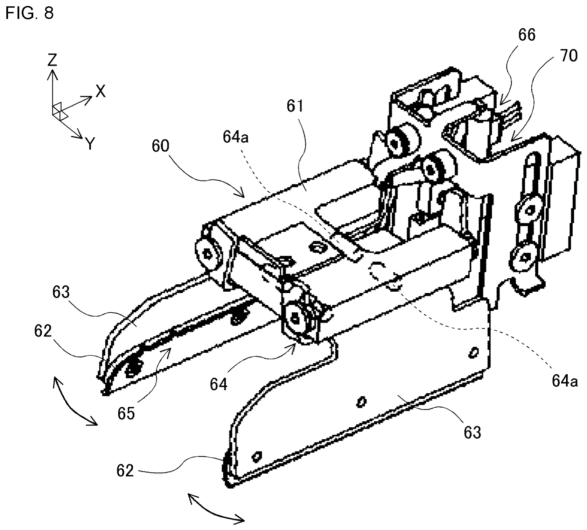

Tape holder 60 is disposed above conveyance path 11. Tape holder 60 can position following tape 2S, and can switch between holding and holding release of following tape 2S. Tape holder 60 is provided in unit body 41. As shown in Figs. 7 and 8, tape holder 60 includes holder base section 61, holding rail 62, rail holding section 63, opening/closing mechanism section 64, positioning section 65, and tape detection sensor 66.

Holder base section 61 is a body section of tape holder 60. Holder base section 61 is fixed to unit body 41. Holder base section 61 is maintained in a substantially horizontal state and is formed in a plate shape.

Holding rail 62 is a rail that is in contact with the lower surface of following tape 2S to hold following tape 2S. Holding rail 62 extends parallel to tape conveyance direction X in feeder 1. An upper surface of holding rail 62 is preferably in a substantially horizontal state, but a rear end side (front side) of holding rail 62 in tape conveyance direction X may be curved upward from a rear side to a front side in tape conveyance direction X such that following tape 2S is stretched from following reel 3S and held by holding rail 62 in a smoothly curved state. Pair of holding rails 62 are provided apart from each other in tape width direction Y. Pair of holding rails 62 are separated from each other by a distance that can achieve the holding when following tape 2S is held.

Rail holding section 63 is a member that holds holding rail 62. Pair of rail holding sections 63 are provided corresponding to holding rails 62. Each rail holding section 63 is erected in a plate shape. Holding rail 62 is disposed on an inner surface side lower portion of rail holding section 63. Each rail holding section 63 is swingably supported by holder base section 61. Rail holding section 63 can swing about an axis extending in tape conveyance direction X. Rail holding section 63 swings between a holding position at which following tape 2S can be held on holding rail 62 and a release position at which the holding can be released.

Opening/closing mechanism section 64 is a mechanism that swings rail holding section 63 between the holding position and the release position in tape holder 60. Opening/closing mechanism section 64 can switch between a state of holding following tape 2S and a state of releasing the holding by swinging rail holding section 63. Opening/closing mechanism section 64 positions rail holding section 63 at the holding position at the timing of holding following tape 2S, and positions rail holding section 63 at the release position at the timing of releasing the holding of following tape 2S. The distance between pair of holding rails 62 is a distance at which following tape 2S can be held at the holding position of rail holding section 63, and is larger at the release position of rail holding section 63 than at the holding position.

Opening/closing mechanism section 64 may operate in conjunction with the operation of moving mechanism 80 described in detail later. Further, the operation of opening/closing mechanism section 64 may be performed using a cam mechanism mechanically connected to moving mechanism 80, or may be performed using power generated by an independent electric motor different from moving mechanism 80.

Opening/closing mechanism section 64 includes spring section 64a. Spring section 64a is, for example, a compression spring that generates a biasing force for biasing rail holding section 63 including holding rail 62 toward the holding position. Opening/closing mechanism section 64 holds rail holding section 63 at the holding position by the biasing force of spring section 64a, and moves rail holding section 63 to the release position against the biasing force of spring section 64a by an external force of the cam mechanism or the drive motor.

Following tape 2S is inserted in tape conveyance direction X into a space above pair of holding rails 62 from the rear side of tape holder 60 in tape conveyance direction X. Both end portions of following tape 2S in tape width direction Y are placed on the upper surfaces of pair of holding rails 62 in a state where rail holding section 63 is at the holding position, so that following tape 2S is held by holding rails 62.

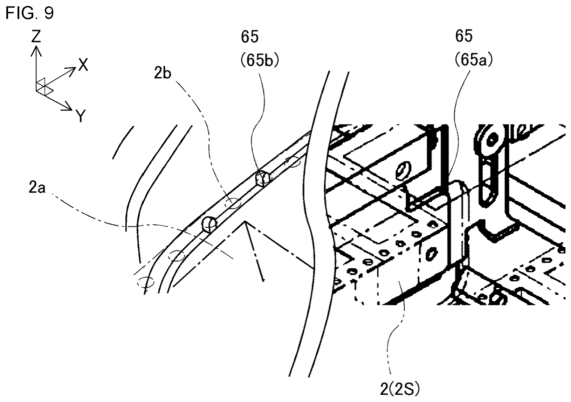

Positioning section 65 is a section that positions following tape 2S in a state where following tape 2S can be connected to preceding tape 2F. As shown in Fig. 9, positioning section 65 includes first stopper 65a and second stopper 65b.

First stopper 65a is a forward end stopper that positions a forward end in tape conveyance direction X of following tape 2S inserted into tape holder 60. First stopper 65a abuts on a front end of following tape 2S to restrict further forward insertion of following tape 2S. It is preferable that first stopper 65a is configured to abut on the front end of following tape 2S itself while avoiding splicing tape 5 attached to a front end portion of following tape 2S.

Second stopper 65b is a falling-off prevention stopper that prevents following tape 2S from falling off from tape holder 60 when following tape 2S is held by tape holder 60. Second stopper 65b is a protrusion that is formed on the upper surface of holding rail 62 and that protrudes upward. Second stopper 65b prevents following tape 2S from falling off from tape holder 60 by being fitted into feed hole 2b of following tape 2S.

Multiple second stoppers 65b may be provided corresponding to the pitches between feed holes 2b in holding rail 62. Second stopper 65b may be provided on each of pair of holding rails 62. Second stopper 65b is configured to be disengaged from feed hole 2b of following tape 2S when rail holding section 63 is changed from the holding position to the release position.

Tape detection sensor 66 is a sensor that detects whether following tape 2S is positioned in a desired state in tape holder 60. Holder base section 61 is provided with jig 67 (see

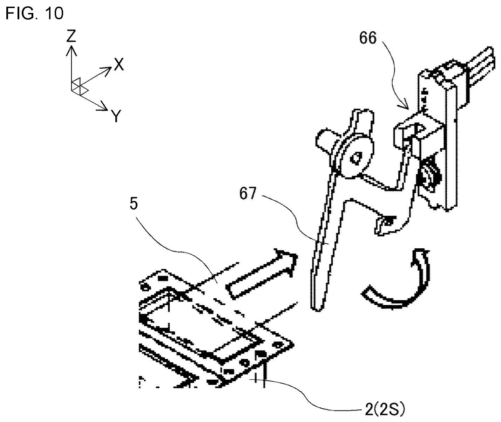

Fig. 10) of which a position changes in accordance with the presence or absence of following tape 2S in tape holder 60. Jig 67 is rotatably supported by holder base section 61. Jig 67 is biased rearward in tape conveyance direction X by its dead weight or a biasing force of a biasing member, and moves forward in tape conveyance direction X against the biasing force when jig 67 abuts on the front end of following tape 2S and is pushed into following tape 2S. Tape detection sensor 66 outputs a signal corresponding to the position of jig 67.

Jig 67 is not pushed forward in tape conveyance direction X when the front end of following tape 2S does not abut on first stopper 65a. In this case, tape detection sensor 66 outputs a signal indicating a state in which following tape 2S is not positioned in tape holder 60. On the other hand, when the front end of following tape 2S abuts on first stopper 65a, jig 67 is pushed forward in tape conveyance direction X and rotates with respect to holder base section 61. In this case, tape detection sensor 66 outputs a signal indicating a state in which following tape 2S is positioned in tape holder 60.

The output signal of tape detection sensor 66 is supplied to control device 90. Control device 90 detects the presence or absence of following tape 2S in tape holder 60 based on the output signal of tape detection sensor 66.

Splicing crimping section 70 is a section that crimps splicing tape 5 to the rear end portion of preceding tape 2F and the front end portion of following tape 2S. Splicing crimping section 70 is provided on tape holder 60. Splicing crimping section 70 is formed in a block shape or a plate shape. It is preferable that splicing crimping section 70 is made of a material such as rubber sponge to flexibly correspond to the state of the upper surface of carrier tape 2.

Splicing tape 5 is joined to the upper surface of the rear end portion of preceding tape 2F (specifically, cover tape 2d) and the upper surface of the front end portion of following tape 2S (specifically, cover tape 2d) by adhesion. Only one splicing tape 5 may be provided between preceding tape 2F and following tape 2S as shown in Fig. 2, or two or more splicing tapes 5 may be provided side by side in parallel.

When conveyance path 11 is lifted by moving mechanism 80 and reaches a spliceable position described later, splicing crimping section 70 crimps the front half of splicing tape 5 and the rear end portion of preceding tape 2F in up-down direction Z and crimps the rear half of splicing tape 5 and the front end portion of following tape 2S in up-down direction Z.

In the present embodiment, after the rear half of splicing tape 5 is attached to the front end portion of following tape 2S, splicing tape 5 is held by tape holder 60 together with following tape 2S. Therefore, splicing crimping section 70 need only be able to crimp at least the front half of splicing tape 5 to the rear end portion of preceding tape 2F in up-down direction Z. However, in order to ensure adhesion between splicing tape 5 and following tape 2S, it is preferable that splicing crimping section 70 can crimp the rear portion of splicing tape 5 and following tape 2S in up-down direction Z.

In addition, splicing crimping section 70 may be provided not only on tape holder 60 but also on conveyance path 11 side in pair with tape holder 60 side to sandwich the front portion of splicing tape 5 and the rear end portion of preceding tape 2F in up-down direction Z and sandwich the rear portion of splicing tape 5 and the front end portion of following tape 2S in up-down direction Z. Splicing crimping section 70 on conveyance path 11 side may be, for example, a bottom wall that can abut on the lower surface of preceding tape 2F in conveyance path 11.

Moving mechanism 80 is a mechanism that relatively moves conveyance path 11 and tape holder 60. Specifically, moving mechanism 80 moves conveyance path 11 in up-down direction Z with respect to tape holder 60 in a state where tape holder 60 is fixed to unit body 41. As shown in Fig. 5, moving mechanism 80 includes movement guide section 81 and movement drive section 82.

A position on a lower side on which conveyance path 11 is moved by moving mechanism 80 is a conveyable position at which preceding tape 2F can be conveyed in tape conveyance direction X while the connection between preceding tape 2F and following tape 2S is restricted. A position on an upper side on which conveyance path 11 is moved is the spliceable position at which the above-described connection can be performed while the conveyance of preceding tape 2F is restricted.

Movement guide section 81 is a section that supports and guides conveyance path 11 to be movable in up-down direction Z with respect to unit body 41. Movement guide section 81 includes body side member 81a attached to unit body 41 and holder side member 81b attached to conveyance path 11. Body side member 81a extends in a rod shape in up-down direction Z. Further, holder side member 81b has a groove portion or a hole portion, into which body side member 81a is fitted, corresponding to body side member 81a. Holder side member 81b moves up and down integrally with conveyance path 11.

Movement drive section 82 is a section that generates a driving force for moving conveyance path 11 in up-down direction Z. Movement drive section 82 is, for example, an electric motor. Movement drive section 82 is attached to unit body 41. When lifting of conveyance path 11 is instructed by a splicing instruction for preceding tape 2F and following tape 2S, movement drive section 82 lifts conveyance path 11 from the conveyable position to the spliceable position. When the connection is completed or a splicing release instruction is issued, movement drive section 82 lowers conveyance path 11 from the spliceable position to the conveyable position.

Control device 90 is a device that controls the operation of feeder 1 (including the operation of splicing device 40 and moving mechanism 80). Control device 90 is configured primarily by a microcomputer. Control device 90 controls driving of each drive section in feeder 1 based on various signals from tape detection sensor 66, component detection sensor 42, and the like. Control device 90 is connected to control device 91 provided in the component mounter, and can transmit an operation status including a result of connection by splicing device 40 in feeder 1 to control device 91.

The result of connection may include a positional relationship between the component pickup position of feeder 1 and the rear end of preceding tape 2F during cutting of preceding tape 2F, a position of the splicing portion of carrier tape 2 in which preceding tape 2F and following tape 2S are integrated after the splicing is completed, and the like.

### 4. Operation of Feeder

In a state in which feeder 1 is mounted in the slot of the component mounter, the worker stretches preceding tape 2F, which is carrier tape 2 wound around preceding reel 3F, from preceding reel 3F, inserts preceding tape 2F into the tape inlet of conveyance path 11 at the conveyable position, and sets preceding tape 2F in feeder 1. Preceding tape 2F is set such that feed hole 2b of carrier tape 2 is engaged with the sprocket on the tape outlet side, and cover tape 2d is completely peeled off from base tape 2c and engaged with winding gear 36.

When feeder 1 is started after the setting, feeder 1 repeats a process of supplying and exposing the component in cavity 2a to the component pickup position by conveying preceding tape 2F by tape conveyance mechanism 30. The component supplied to the component pickup position is taken out from cavity 2a by the operation of the component mounter and mounted on the electronic board.

In addition, following tape 2S, which is carrier tape 2 wound around following reel 3S, can be set with respect to the same feeder 1 at any timing during the board production in which the component of preceding tape 2F set in feeder 1 is mounted by the component mounter as described above or before the board production.

Specifically, first, the worker stretches following tape 2S from following reel 3S at any timing during the board production or before the board production, cuts following tape 2S at a portion on a front side of a leading component (hereinafter, referred to as a leading component) in performing the tape conveyance among the components accommodated in cavities 2a, and attaches the rear half of splicing tape 5 to the upper surface of the front end portion of following tape 2S after the cutting by adhesion. Then, the worker inserts following tape 2S into the tape inlet of tape holder 60, makes the front end of following tape 2S abut on first stopper 65a of positioning section 65, and hooks feed hole 2b on second stopper 65b, thereby causing tape holder 60 to hold following tape 2S.

Rail holding section 63 of tape holder 60 need only be positioned at the holding position by opening/closing mechanism section 64 when holding rail 62 holds following tape 2S. For example, rail holding section 63 may be positioned at the release position at a timing when following tape 2S is inserted into the tape inlet of tape holder 60 by the worker, and then changed in position to the holding position at a timing when jig 67 comes into contact with the front end of following tape 2S to be pushed and tape detection sensor 66 detects the presence of following tape 2S.

When following tape 2S is held by tape holder 60 as described above, tape detection sensor 66 detects that following tape 2S is positioned in tape holder 60, and outputs a signal indicating the state of the positioning to control device 90 of feeder 1. Accordingly, control device 90 of feeder 1 recognizes that following tape 2S is set in tape holder 60, and recognizes that the connection between following tape 2S to preceding tape 2F is prepared.

When the number of remaining components in preceding tape 2F decreases due to the above-described board production, control device 90 detects the final component in preceding tape 2F based on the output signal of component detection sensor 42 and specifies the position of the final component. When the final component is detected, first, control device 90 adjusts the conveyance position of preceding tape 2F by driving the drive motor of tape conveyance mechanism 30 such that the central portion in tape conveyance direction X between cavity 2a in which the final component is accommodated and empty cavity 2e in preceding tape 2F becomes the splicing portion. The conveyance direction and the conveyance distance of preceding tape 2F are determined in accordance with the disposition position of component detection sensor 42, the disposition position of cutter 51 of cutting device 50, and the like.

When the conveyance of preceding tape 2F for positioning the splicing portion is completed, control device 90 then drives cutter drive section 53 of cutting device 50 to lift cutter holding section 55 and thus cutter 51 from the lower end position (the state shown in Fig. 5) and move pressing section 54 toward above cutter 51 (see (A) of Fig. 6). When such a process is performed, preceding tape 2F is cut at the splicing portion while being immovably pressed by pressing section 54 before cutter 51 reaches the upper end position.

When preceding tape 2F is cut, a portion on the front side of the splicing portion in preceding tape 2F (specifically, the side on which cavity 2a in which the component is still accommodated is present) is pressed by pressing section 54, and a portion on the rear side of the splicing portion in preceding tape 2F (specifically, the side on which empty cavity 2e is present) is discharged to the outside of feeder 1 as waste tape 2Z (see Fig. 4).

When cutter 51 reaches the upper end position (see (B) of Fig. 6), cutter holding section 55 and cutter 51 are lowered from the upper end position and returned to the lower end position, and pressing section 54 is returned from the position above cutter 51 to the original position (see Fig. 5). In this case, control device 90 stores the positional relationship between the component pickup position of feeder 1 and the rear end of preceding tape 2F.

When the cutting of preceding tape 2F is completed, control device 90 adjusts the conveyance position of preceding tape 2F by driving the drive motor of tape conveyance mechanism 30 such that the position of the rear end of preceding tape 2F, which accommodates the final component, in tape conveyance direction X coincides with the position of the front end of following tape 2S, which is held by tape holder 60, in tape conveyance direction X. When this conveyance process is performed, the position of the rear end of preceding tape 2F in tape conveyance direction X coincides with the position of the front end of following tape 2S in tape conveyance direction X in a state where preceding tape 2F and following tape 2S are separated from each other in up-down direction Z.

The conveyance direction and the conveyance distance of preceding tape 2F described above may be determined in accordance with a change in the position of the rear end of preceding tape 2F due to the upward movement of conveyance path 11. In addition, the rear end of preceding tape 2F and the front end of following tape 2S need only be positioned such that the pitch between feed holes 2b before and after the splicing portion of preceding tape 2F and following tape 2S is the multiple of "4 mm". In addition, the rear end of preceding tape 2F and the front end of following tape 2S may abut on each other in the connected state, or may have gap L. Gap L is set in a range of, for example, 8 mm or less corresponding to the pitch between feed holes 2b, and specifically, is set such that the pitch between feed holes 2b before and after the splicing portion is the multiple of "4 mm".

Further, in a case where gap L is formed between the rear end of preceding tape 2F and the front end of following tape 2S as described above, when cavity 2a before and after the splicing portion in carrier tape 2 reaches the component pickup position of feeder 1 after preceding tape 2F and following tape 2S are connected to each other, the conveyance control by feeder 1, that is, the drive motor control of tape conveyance mechanism 30 may be corrected in accordance with the pitch between feed holes 2b before and after the splicing portion.

Next, control device 90 drives movement drive section 82 of moving mechanism 80 to lift conveyance path 11 to the spliceable position such that preceding tape 2F of conveyance path 11 and following tape 2S of tape holder 60 are connected to each other. When such a process is performed, conveyance path 11 slides upward in an approaching direction with respect to tape holder 60. When conveyance path 11 reaches the spliceable position, splicing crimping section 70 of splicing device 40 crimps splicing tape 5 to preceding tape 2F and following tape 2S to connect preceding tape 2F and following tape 2S to each other.

When the connection between preceding tape 2F and following tape 2S is completed, control device 90 then drives movement drive section 82 of moving mechanism 80 to lower conveyance path 11 to the conveyable position, and operates opening/closing mechanism section 64 of tape holder 60 to change the position of rail holding section 63 from the holding position to the release position. When such a process is performed, conveyance path 11 slides downward in a separating direction with respect to tape holder 60, and rail holding section 63 is opened toward the release position.

The lowering of conveyance path 11 by moving mechanism 80 and the position change of rail holding section 63 to the release position by opening/closing mechanism section 64 of tape holder 60 may be performed in conjunction with each other, or may be performed at different timings. Further, the lowering of conveyance path 11 by moving mechanism 80 may be temporarily stopped at an intermediate position before conveyance path 11 reaches a lowermost end position of the conveyable position. The lowering stop may be performed, for example, in order to reduce stress applied to the splicing portion after the connection between preceding tape 2F and following tape 2S in carrier tape 2, and may be continued until the splicing portion moves to feeder main body 10 side.

When rail holding section 63 reaches the release position, the holding of following tape 2S is released from a state where following tape 2S is held by holding rail 62. When conveyance path 11 is lowered to the conveyable position, preceding tape 2F and following tape 2S connected to preceding tape 2F are integrally set in feeder 1, and can be conveyed in tape conveyance direction X by the operation of tape conveyance mechanism 30. Further, when following tape 2S is integrated with preceding tape 2F by splicing, and the holding by tape holder 60 is released, next following tape 2S can be inserted and set into tape holder 60.

After the connection between preceding tape 2F and following tape 2S is completed, control device 90 stores the position of the splicing portion of carrier tape 2 in which preceding tape 2F and following tape 2S are integrated, and notifies control device 91 of the component mounter at the upper level that carrier tape 2 from which the component is taken out before and after the position of the splicing portion is switched from preceding tape 2F to following tape 2S.

As described above, feeder 1 includes splicing device 40 that connects preceding tape 2F being conveyed, which is conveyed and supported by conveyance path 11, and following tape 2S for replenishment held by tape holder 60 to each other by using splicing tape 5. Therefore, it is possible to ensure the connection between preceding tape 2F being conveyed, which is conveyed and supported by conveyance path 11, and following tape 2S for replenishment held by tape holder 60. Further, with this configuration, splicing is performed in a state where the rear end of preceding tape 2F and the front end of following tape 2S are butted against each other, and thus it is possible to ensure superiority of the connection using splicing tape 5.

Specifically, since cover tape 2d of preceding tape 2F and cover tape 2d of following tape 2S are connected to each other via splicing tape 5, base tape 2c and cover tape 2d of preceding tape 2F and base tape 2c and cover tape 2d of following tape 2S do not overlap in this order in the tape thickness direction after the connection using splicing tape 5. Therefore, after the above-described connection, peeling off of cover tape 2d from base tape 2c in preceding tape 2F and peeling off of cover tape 2d from base tape 2c in following tape 2S can be continuously performed without any special work. That is, separation of cover tape 2d can be continued before and after the joint portion between preceding tape 2F and following tape 2S without peel-off work by the worker. Therefore, it is possible to achieve the conveyance of carrier tape 2 after the connection between preceding tape 2F and following tape 2S without imposing a work burden on the worker.

Splicing device 40 includes cutting device 50 that cuts preceding tape 2F conveyed and supported by conveyance path 11. With cutting device 50, in connecting preceding tape 2F and following tape 2S, it is possible to remove an unnecessary portion of preceding tape 2F (specifically, a portion in which empty cavity 2e on the rear side in tape conveyance direction X with respect to cavity 2a of the final component is present) and leave a necessary portion. Therefore, since the components accommodated in cavities 2a in carrier tape 2 after the connection can be continuous before and after the joint portion between preceding tape 2F and following tape 2S, the conveyance control of carrier tape 2 can be prevented from being complicated, and the conveyance control can be simplified.

Splicing device 40 includes component detection sensor 42 that detects the components accommodated in preceding tape 2F. With this configuration, before cutting device 50 cuts preceding tape 2F, the final component in preceding tape 2F can be detected using component detection sensor 42. In addition, with the detection of the final component, the splicing portion of preceding tape 2F can be adjusted by conveying preceding tape 2F in tape conveyance direction X using tape conveyance mechanism 30. Therefore, since the cutting of preceding tape 2F by cutting device 50 can be performed at an appropriate portion immediately after the final component in tape conveyance direction X, cavity 2a in which the component is not accommodated in carrier tape 2 after the connection can be eliminated, and the conveyance control of carrier tape 2 can be efficiently performed.

Feeder 1 includes moving mechanism 80 that relatively moves conveyance path 11 that conveys and supports preceding tape 2F and tape holder 60 that holds following tape 2S. Splicing device 40 connects the rear end portion of preceding tape 2F and the front end portion of following tape 2S in a state where conveyance path 11 and tape holder 60 are positioned at the spliceable position by the relative movement by moving mechanism 80.

The movement of conveyance path 11 in the approaching direction with respect to tape holder 60 by moving mechanism 80 and the splicing by splicing device 40 are also performed during the board production in the component mounter as long as following tape 2S is held by tape holder 60 to be spliceable. For this reason, since carrier tape 2 can be replenished without a significant operation stop even during the board production by the component mounter, it is possible to improve the device operation rate.

In addition, the movement of conveyance path 11 in the approaching direction with respect to tape holder 60 by moving mechanism 80 and the splicing by splicing device 40 are automatically performed without the operation of the worker when the final component in preceding tape 2F is detected, as long as following tape 2S is held in tape holder 60 to be spliceable. Therefore, even when the number of remaining components in preceding tape 2F is small during the board production by the component mounter, carrier tape 2 can be replenished without forcing the worker to perform the splicing work of preceding tape 2F and following tape 2S, and thus the production efficiency can be increased, and labor saving can be achieved while reducing the work burden of the worker.

In addition, the work of holding following tape 2S on tape holder 60 by the worker need only be performed at any timing as long as the timing is before the connection between preceding tape 2F and following tape 2S. Therefore, since the work of holding following tape 2S on tape holder 60 by the worker can be performed at a free timing before the connection between preceding tape 2F and following tape 2S, the degree of freedom of the work of a worker can be improved, and the work efficiency can be improved.

Splicing device 40 is provided integrally with feeder 1. Then, moving mechanism 80 moves conveyance path 11 between the conveyable position and the spliceable position with respect to tape holder 60. Therefore, it is possible to complete the conveyance of carrier tape 2 and the replenishment of carrier tape 2 when the number of remaining components is small by one feeder 1.

Further, feeder 1 includes control device 90 that controls splicing device 40. Then, control device 90 transmits the result of connection, by splicing device 40, between preceding tape 2F being conveyed and following tape 2S for replenishment to control device 91 of the component mounter. When receiving the result of connection by splicing device 40 from control device 90 of feeder 1, control device 91 of the component mounter associates the result of connection with identification information (ID) of feeder 1 and uses the result of connection for subsequent board production and board information in the component mounter. For example, control device 91 can recognize that the component of carrier tape 2, which is the conveyance target, is switched from that in preceding tape 2F to that in following tape 2S, and can distinguish whether the component that is to be mounted or that is mounted on the board is that in preceding tape 2F or that in following tape 2S.

In the above-described embodiment, moving mechanism 80 that relatively moves conveyance path 11 and tape holder 60 causes conveyance path 11 to move by sliding in up-down direction Z. However, the present disclosure is not limited thereto, and moving mechanism 80 may cause tape holder 60 to move by sliding in up-down direction Z, or may cause both conveyance path 11 and tape holder 60 to move by sliding in up-down direction Z.

In addition, in the above-described embodiment, following tape 2S is held by tape holder 60 in a state where splicing tape 5 is attached to the front end portion of following tape 2S in advance by the worker, and splicing device 40 has splicing crimping section 70. When moving mechanism 80 causes conveyance path 11 to move by sliding in up-down direction Z and conveyance path 11 reaches the spliceable position from the conveyable position side, preceding tape 2F on conveyance path 11 is crimped to splicing tape 5 by being crimped to splicing crimping section 70, and the connection between preceding tape 2F and following tape 2S of tape holder 60 is performed.

However, the present disclosure is not limited thereto, and following tape 2S may be held by tape holder 60 without attaching splicing tape 5, and splicing device 40 may include a robot or the like that takes out splicing tape 5 from a splicing tape storage section and attaches splicing tape 5 to at least one of preceding tape 2F and following tape 2S before the connection between preceding tape 2F and following tape 2S. The attachment of splicing tape 5 by the robot or the like may be performed, for example, after conveyance path 11 reaches the spliceable position from the conveyable position side by the sliding movement by moving mechanism 80.

In the above-described embodiment, splicing device 40 is provided integrally with feeder 1. However, the present disclosure is not limited thereto, and splicing device 40 may be detachably provided in feeder 1. In the structure of this modification example, the portion of splicing device 40, which is attached to and detached from feeder 1, may be entire splicing device 40 or may be limited to a part of splicing device 40.

Further, in the above-described embodiment, control device 90 of feeder 1 transmits the result of connection between preceding tape 2F and following tape 2S by splicing device 40 to control device 91 of the component mounter. However, the present disclosure is not limited thereto, and control device 90 may transmit the result of connection to host computer 92 communicably connected to the component mounter. With the configuration of this modification example, the host computer can use the result of connection by each splicing device 40, for example, for subsequent board production and board information in all component mounters in a factory.

The present disclosure is not limited to the above-described embodiment or the modification examples, and various changes can be made without departing from the gist of the present disclosure. In addition, the present disclosure not only discloses the technical idea indicated by the citation relationship described in each claim as originally filed, but also discloses the technical idea in which the matters described in each claim are combined as appropriate.

### Reference Signs List

1: feeder, 2: carrier tape, 2a: cavity, 2b: feed hole, 2c: base tape, 2d: cover tape, 2F: preceding tape, 2S: following tape, 3: reel, 3F: preceding reel, 3S: following reel, 10: feeder main body, 11: conveyance path, 20: tape guide, 30: tape conveyance mechanism, 35: cover tape discharge mechanism, 40: splicing device, 41: unit body, 42: component detection sensor, 50: cutting device, 51: cutter, 60: tape holder, 70: splicing crimping section, 80: moving mechanism, 90,91: control device, 92: host computer.

## Claims

1. A feeder for conveying a carrier tape accommodating components, the feeder comprising:
a splicing device configured to connect a rear end portion of the carrier tape being conveyed and a front end portion of the carrier tape for replenishment to each other by using a connection member.

2. The feeder according to Claim 1, wherein the splicing device includes a cutting device configured to cut the carrier tape being conveyed.

3. The feeder according to Claim 2, wherein the splicing device includes a component detection sensor configured to detect the component accommodated in the carrier tape being conveyed.

4. The feeder according to Claim 3, wherein the cutting device cuts a predetermined portion on a rear side of a final component among the components accommodated in the carrier tape being conveyed detected by the component detection sensor.

5. The feeder according to Claim 4, further comprising:
a moving mechanism configured to relatively move a conveyance path that conveys and supports the carrier tape being conveyed and a tape holder that holds the carrier tape for replenishment,
wherein the splicing device connects the rear end portion of the carrier tape being conveyed, which is cut by the cutting device, and the front end portion of the carrier tape for replenishment, the carrier tape being conveyed and the carrier tape for replenishment being positioned by the conveyance path and the tape holder that are relatively moved by the moving mechanism.

6. The feeder according to Claim 5, further comprising:
a control device configured to control the splicing device,
wherein the control device transmits a result of connection by the splicing device between the carrier tape being conveyed and the carrier tape for replenishment to a component mounter or a host computer communicably connected to the component mounter.
